(19) Europäisches Patentamt
European Patent Office
Office européen des brevets

(11) **EP 3 203 253 B1**

(12) **EUROPEAN PATENT SPECIFICATION**

(45) Date of publication and mention
of the grant of the patent:
**31.07.2019 Bulletin 2019/31**

(51) Int Cl.:
***G01R 33/07*** (2006.01)   ***H01L 43/06*** (2006.01)

(21) Application number: **15845690.5**

(22) Date of filing: **28.08.2015**

(86) International application number:
**PCT/JP2015/074318**

(87) International publication number:
**WO 2016/052028 (07.04.2016 Gazette 2016/14)**

(54) **HALL SENSOR**

HALLSENSOR

CAPTEUR À EFFET HALL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.09.2014 JP 2014202015**

(43) Date of publication of application:
**09.08.2017 Bulletin 2017/32**

(73) Proprietor: **ABLIC Inc.**
**Chiba 261-8507 (JP)**

(72) Inventors:
• **HIOKA, Takaaki**
**Chiba-shi, Chiba 261-8507 (JP)**
• **HIKICHI, Tomoki**
**Chiba-shi, Chiba 261-8507 (JP)**

(74) Representative: **Miller Sturt Kenyon**
**9 John Street**
**London WC1N 2ES (GB)**

(56) References cited:
**WO-A1-2005/073744     JP-A- 2013 201 229
JP-A- 2014 066 522     JP-A- 2014 066 522
US-A1- 2010 217 556     US-A1- 2014 084 911**

EP 3 203 253 B1

**Description**

Technical Field

The present invention relates to a semiconductor Hall element and a Hall sensor including a circuit configured to drive the semiconductor Hall element, in particularly, to a Hall sensor capable of eliminating an offset voltage.

Background Art

First, the principle of magnetic detection by a Hall element is described. When a magnetic field is applied perpendicularly to a current flowing through a substance, an electric field (Hall voltage) is generated in a direction perpendicular to both the current and the magnetic field. The principle of the magnetic detection by the Hall element is to acquire an intensity of the magnetic field based on a magnitude of the Hall voltage.

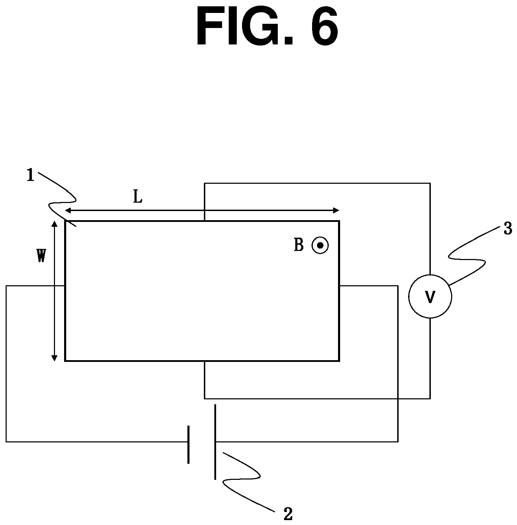

In a Hall element as illustrated in FIG. 6, a Hall voltage VH appearing on a voltmeter 3 is represented as:

$$VH=\mu B(W/L)Vdd,$$

where W and L represent respectively a width and a length of a magnetism sensing portion 1 of the Hall element, $\mu$ represents electron mobility, Vdd represents a voltage applied by a power supply 2 for supplying a current, and B represents an applied magnetic field. A coefficient proportional to the applied magnetic field B corresponds to a magnetic sensitivity, and hence a magnetic sensitivity Kh of this Hall element is represented as:

$$Kh=\mu(W/L)Vdd.$$

Meanwhile, in an actual Hall element, an output voltage comes out even in the absence of the applied magnetic field. The voltage output under a zero magnetic field is called offset voltage. Reason for the appearance of the offset voltage is considered to be imbalance of electric potential distribution inside the element due to, for example, mechanical stress applied to the element from the outside thereof or misalignment occurring in a manufacturing process.

The offset voltage is generally compensated for by the following method.

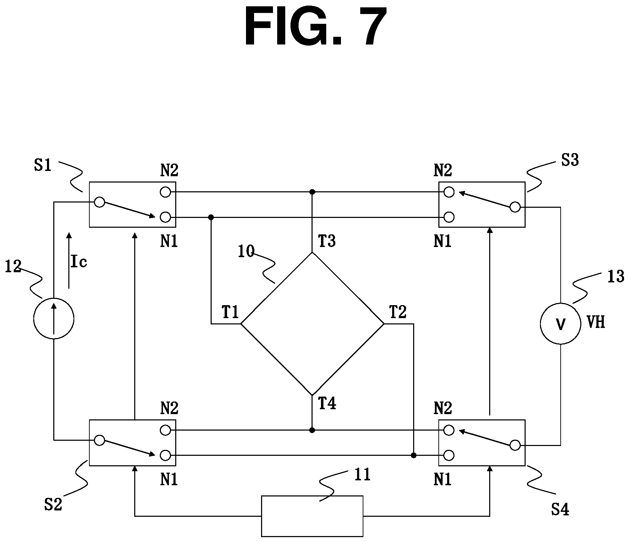

FIG. 7 is a circuit diagram for illustrating the principle of an offset cancellation circuit utilizing spinning current. A Hall element 10 has a symmetrical shape and includes four terminals T1, T2, T3, and T4 so that a control current is caused to flow between one pair of input terminals and an output voltage is obtained between the other pair of output terminals. When one pair of the terminals T1 and T2 of the Hall element serve as control current input terminals, the other pair of the terminals T3 and T4 serve as Hall voltage output terminals. In this case, when a voltage Vin is applied between the input terminals, an output voltage Vh+Vos is generated between the output terminals, where Vh represents a Hall voltage proportional to a magnetic field generated by the Hall element and Vos represents an offset voltage. Further, with the terminals T3 and T4 serving as the control current output terminals and the terminals T1 and T2 serving as the Hall voltage output terminals, when the input voltage Vin is applied between the terminals T3 and T4, a voltage -Vh+Vos is generated between the output terminals. Reference symbols S1 to S4 denote sensor terminal switching means, and one of terminals N1 and N2 is selected by a switching signal generator 11.

By subtracting one output voltage from the other which are obtained by the currents flowing in two directions described above, the offset voltage Vos may be cancelled to obtain an output voltage 2Vh proportional to the magnetic field (see, for example, Patent Literature 1).

However, the offset voltage may not completely be cancelled by this offset cancellation circuit. A description is now given of a reason therefor.

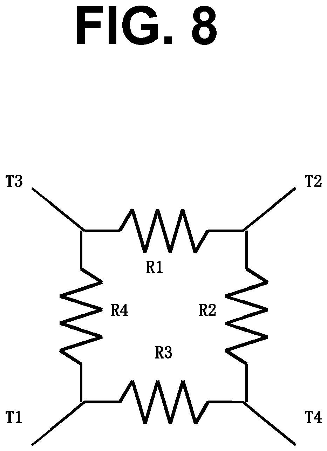

The Hall element is represented as an equivalent circuit illustrated in FIG. 8. Specifically, the Hall element may be represented as a bridge circuit in which the four terminals are connected via four resistors R1, R2, R3, and R4. Based on this model, a description is given of the cancellation of the offset voltage by subtracting one output voltage from the other which are obtained by the currents flowing in the two directions as described above.

When the voltage Vin is applied between the one pair of terminals T1 and T2 of the Hall element, the following Hall voltage is output between the other pair of terminals T3 and T4:

$$Vouta=(R2*R4-R1*R3)/(R1+R4)/(R2+R3)*Vin$$

Meanwhile, when the voltage Vin is applied between the terminals T3 and T4, the following Hall voltage is output between the terminals T1 and T2:

$$Voutb=(R1*R3-R2*R4)/(R3+R4)/(R1+R2)*Vin$$

Then, the difference between the output voltages for the two directions is acquired as:

$$Vouta-Voutb=(R1-R3)*(R2-R4)*(R2*R4-R1*R3)/(R1+R4)/(R2+R3)/(R3+R4)/(R1+R2)*Vin.$$

Thus, the offset voltage may be cancelled even when the respective resistors R1, R2, R3, and R4 of the equivalent circuit are different from each other, as long as R1=R3 or R2=R4. In this case, it is assumed that the respective resistance values do not change even when the terminals to be applied with the voltage are changed. However, when this assumption is not satisfied, for example, when R1=R3 is established for one direction but this relationship is not established for the other direction, the difference may not be made zero, and hence the offset may not be cancelled. A specific description is further given of one of reasons why the offset may not be cancelled by changing the application directions of the voltage.

The Hall element generally has such a structure that a peripheral portion of an N-type doped region, which is to serve as the Hall element magnetism sensing portion, is surrounded by a P-type doped region for isolation. When a voltage is applied between the Hall current application terminals, a depletion layer expands at a boundary between the Hall element magnetism sensing portion and its peripheral portion. No Hall current flows in the depletion layer, and hence in a region of the expanding depletion layer, the Hall current is suppressed to increase the resistance. Further, the width of the depletion layer depends on the applied voltage. Accordingly, the resistance values of the resistors R1, R2, R3, and R4 of the equivalent circuit illustrated in FIG. 8 change depending on the voltage application direction, and hence in some cases, the offset cancellation circuit may not cancel a magnetic offset.

There may be employed a method involving arranging depletion layer control electrodes around and above the element, and adjusting voltages applied to the respective electrodes, to thereby suppress the depletion layer from extending into the Hall element (see, for example, Patent Literature 2).

Citation List

Patent Literature

[PTL 1] JP 06-186103 A
[PTL 2] JP 08-330646 A
[PTL 3] US2010/217556 discloses a method for a determination, section after section, of a parameter-dependent correction value approximation course includes determining a first measurement signal value with a first parameter value associated with a sensor arrangement when the first parameter value fulfils a predetermined condition or a trigger condition is fulfilled, changing the first parameter value to obtain a second parameter value, determining a second signal value with the second parameter value and determining a second partial section of the correction value approximation course for a second parameter range based on a functional connection describing the second partial section, the first parameter value, the second parameter value, the first measurement signal value, the second measurement signal value and an initial correction value.
[PTL 4] WO2005/073744 discloses a magnetic field sensor with at least two Hall plates. The magnetic field sensor is equipped to generate measuring currents in a number of directions in the Hall plates and to measure a potential difference over the Hall plates in a direction in the plane of the Hall plate, wherein the direction is always essentially perpendicular to the direction of the measuring current. The measured potential difference is a measure for the magnetic field through the Hall plate in a direction that is essentially perpendicular to the direction of the measuring current and the measured potential difference. The magnetic field sensor is equipped to generate a measuring current in at least eight directions in each Hall plate.
[PTL 5] US2014/084911 discloses multi-terminal sensor devices and operating methods thereof that can reduce or eliminate offset error. Sensor devices can comprise three or fewer terminals, and multiple such sensor devices can be combined. The sensor devices can comprise Hall sensor devices, such as vertical Hall devices, or other sensor devices in embodiments. Operating modes can be implemented for the multi-terminal sensor devices which offer improvements over conventional spinning current techniques, including reduced residual offset.

[PTL 6] JP2014066522 discloses a semiconductor Hall sensor which can decrease an offset voltage at a high temperature. A center line connecting a center of a first terminal and a third terminal to which an internal power supply voltage is applied and a center of a second terminal and a fourth terminal to which an earth voltage is applied is equal to a center line of a hall element. The hall element and an output transistor are laid out in a manner to be symmetric about the center line. Namely, the center line of the hall element coincides with a center line of the output transistor.

Summary of Invention

Technical Problem

When the temperature in the Hall element 10 is not uniform, but has a distribution, the resistance in the Hall element 10 is not uniform, either, because the temperature is not uniform, the resistance value is low in some locations low and high in some locations. An attempt to cancel the offset by the spinning current thus fails since the resistance values of the resistors R1, R2, R3, and R4 have been changed by the temperature.

Accordingly the offset voltage may not be eliminated by the spinning current method disclosed in Patent Literature 1 in the Hall sensor including the Hall element and elements serving as heat sources in a circuit configured to drive the Hall element since the temperature distribution is generated in the Hall element 10 due to the influence of heat generation.

Moreover, the resistance values may be adjusted by the method disclosed in Patent Literature 2, but the method uses the plurality of depletion layer control electrodes and requires a complex control circuit, and hence has such a problem that the chip size increases, which leads to an increase in cost.

In view of the above, the present invention has an object to provide a Hall sensor including elements serving as heat sources out of components of a circuit configured to drive a Hall element, and capable of cancelling an offset by spinning current even when a temperature distribution is generated in a Hall element 120 due to the influence of heat generation, without a complex compensation circuit and an increase in chip area for separation.

Solution to Problem

In order to solve the above-mentioned problem, according to an embodiment of the present invention, there is provided a Hall sensor as defined in claim 1.

Advantageous Effects of Invention

Through use of the above-mentioned measures, in the Hall sensor including elements serving as the heat sources out of components of the circuit configured to drive the Hall element, even when a temperature distribution is generated in the Hall element due to the influence of the heat generation, the offset voltage can be eliminated by the spinning current.

Moreover, since a complex circuit is not used and the distance between the heat source and the Hall element does not increase, the offset voltage can be eliminated, the chip size can be reduced and the cost can be suppressed.

Brief Description of the Drawings

FIG. 1 is a plan view for illustrating a Hall sensor according to a first embodiment of the present invention.
FIG. 2 is a plan view for illustrating a Hall sensor according to a second embodiment of the present invention.
FIG. 3 is a plan view for illustrating a Hall sensor according to a third embodiment of the present invention.
FIG. 4 is a plan view for illustrating a Hall sensor according to a fourth embodiment of the present invention.
FIG. 5 is a graph for showing a relationship between an offset voltage by a spinning current and a temperature distribution in order to explain a positional relationship between a Hall element and a heat source.
FIG. 6 is a diagram for illustrating the principle of the ideal Hall effect.
FIG. 7 is a diagram for illustrating a method of eliminating the offset voltage by the spinning current.
FIG. 8 is a diagram of an equivalent circuit for illustrating the offset voltage of the Hall element.

Description of Embodiments

Embodiments of the present invention are described in detail with reference to the drawings.

First Embodiment

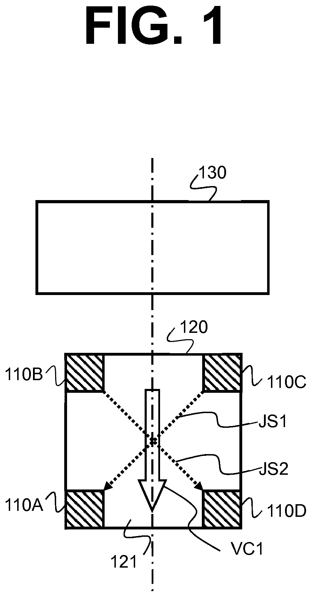

FIG. 1 is a plan view for illustrating a Hall sensor according to a first embodiment of the present invention. The Hall sensor includes a Hall element configured to sense magnetism and a circuit configured to drive or control the Hall element.

First, a description is given of a shape of the Hall element. As illustrated in FIG. 1, a Hall element 120 includes, on a semiconductor substrate, a magnetism sensing portion constructed by a square N-type doped region 121 and control current input terminals and Hall voltage output terminals 110A, 110B, 110C, and 110D constructed by N-type highly-doped regions having the same shape, which are arranged at respective vertices of the square magnetism sensing portion. The Hall element 120 is configured as described above, resulting in a symmetrical Hall element.

A description is now given of a positional relationship between the Hall element and a heat source. A circuit configured to drive the Hall element 120 is arranged on the substrate on which the Hall element 120 is formed. The circuit often includes an element serving as a heat source 130. For example, when an internal circuit of the semiconductor Hall sensor uses, instead of a power supply voltage, an internal power supply voltage generated by stepping down the power supply voltage by a voltage regulator, the voltage regulator may be the heat source. Further, a resistor element, through which a large current flows, or other elements may be the heat source. Thus, as illustrated in FIG. 1, a center of the heat source 130 is aligned with a straight line along a vector sum VC1 of Hall element control currents JS1 and JS2 that are caused to flow through the Hall element 120 in two directions by the spinning current method. As a result, the influence of the heat from the heat source 130 on an offset of the Hall element may be eliminated.

On this occasion, the center of the heat source means a point or a region having the highest temperature corresponding to a peak of isotherms drawn to represent a temperature gradient when the heat source is viewed from above.

The Hall element preferably has a shape that is line-symmetrical about the straight line along the vector sum of the Hall element control currents JS1 and JS2 in the two directions by the spinning current method.

A description is now given of the principle of the elimination of the offset of the Hall element by the above-mentioned form.

The control current input terminals and Hall voltage output terminals 110A, 110B, 110C, and 110D constructed by the N-type highly-doped regions of the Hall element 120 of FIG. 1 are respectively connected to T1, T3, T2, and T4 of FIG. 7. In an equivalent circuit of FIG. 8, it is assumed that the relationship of R2=R4 is established when the temperature is a room temperature and a temperature gradient does not exist. Then the offset may be cancelled by the spinning current. Then, when temperatures of the respective resistors are different from one another, or a temperature gradient exists, the respective resistance values are different from one another. Here, it is assumed that R2 becomes R2', and R4 becomes R4'. When a temperature gradient exists, the relationship of R2'≠R4' is generally established. R1≠R3 is established, and R1'≠R3' is established even when a temperature gradient is generated.

A description is given while using the equations described above again. When the temperature is the room temperature, the temperature gradient does not exist, and a voltage Vin is applied between the one pair of terminals T1 and T2, the Hall element control current JS1 flows, and the following Hall voltage is output between the other pair of terminals T3 and T4:

$$Vouta = (R2*R4-R1*R3)/(R1+R4)/(R2+R3)*Vin.$$

Meanwhile, when the voltage Vin is applied between the terminals T3 and T4, the current JS2 flows, and the following Hall voltage is output between the terminals T1 and T2:

$$Voutb = (R1*R3-R2*R4)/(R3+R4)/(R1+R2)*Vin.$$

On this occasion, when the difference between the output voltages in the two directions is directly acquired by the spinning current, the relationship of R2=R4 is established under the state in which the temperature gradient does not exist based on the assumption, and hence the offset voltage may be made zero in the following equation:

$$Vouta-Voutb = (R1-R3)*(R2-R4)*(R2*R4-R1*R3)/(R1+R4)/(R2+R3)/(R3+R4)/(R1+R2)*Vin.$$

However, when a temperature gradient is generated, the resistance values are different from each other, and R2 becomes R2' and R4 becomes R4'. Consequently the difference in the output voltage takes a value represented by the following equation, and may not be made zero:

$$Vouta'-Voutb'=(R1'-R3')*(R2'-R4')*(R2'*R4'-$$

$$R1'*R3')/(R1'+R4')/(R2'+R3')/(R3'+R4')/(R1'+R2')*Vin.$$

However, by setting the positional relationship between the Hall element and the heat source such that the extension line of the vector sum VC1 of the Hall element control currents JS1 and JS2 in the two directions by the spinning current method aligns with the center of the heat source 130 as illustrated in FIG. 1, the relationship of R2'=R4' may be established while the relationship of R2=R4 is maintained even when the resistors R2 and R4 receive the influence of the heat generation to become R2' and R4', because the resistors R2 and R4 are arranged so as to be symmetrical about the straight line along the vector sum VC1 of the Hall element control currents JS1 and JS2 in the two directions, and hence the resistors R2 and R4 are on the same temperature gradient.

Thus, the difference between the output voltages is represented as:

$$Vout=Vouta'-Voutb'=0.$$

The offset voltage may thus be eliminated by the spinning current.

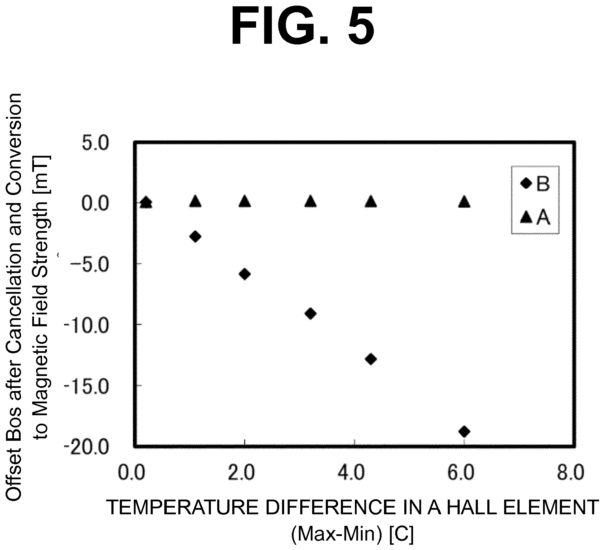

Moreover, FIG. 5 is an experiment graph for showing temperature differences between the maximum and the minimum in the Hall element and magnetic-field-equivalent values of offsets after the offsets are eliminated by the spinning current. Legends A denote measurement results of a case where the arrangement of the first embodiment illustrated in FIG. 1 is used. Legends B denote measurement results of a case where the heat source is arranged perpendicular to the Hall element control current vector sum VC1. Also from the measurement results of FIG. 5, it is appreciated that the offsets may be eliminated by setting the positional relationship between the Hall element and the heat source as illustrated in FIG. 1.

Second Embodiment

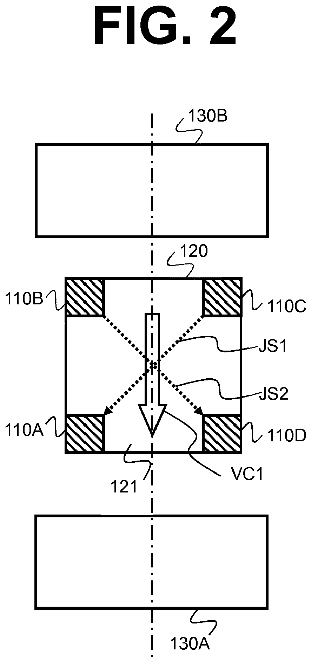

In the first embodiment, referring to FIG. 1, a description is given of the case where the number of the heat sources is one, but the number of elements that generate heat out of components of the circuit configured to control the Hall element is not limited to one. FIG. 2 is a plan view for illustrating a Hall sensor according to an embodiment of the present invention that includes a plurality of elements (heat sources) 130A and 130B that generate heat out of components of the circuit configured to control the Hall element 120.

Even in the case where the plurality of heat sources exist, the offset may be eliminated by aligning the centers of the respective heat sources 130A and 130B with an extension line of the vector sum VC1 of the Hall element control currents JS1 and JS2 in the two directions by the spinning current method.

On this occasion, the center of the heat source means a point or a region having the highest temperature corresponding to a peak of isotherms drawn to represent a temperature gradient when the heat source is viewed from above.

The Hall element preferably has a shape that is line-symmetrical about the straight line passing through the vector sum of the Hall element control currents JS1 and JS2 in the two directions by the spinning current method.

Third Embodiment

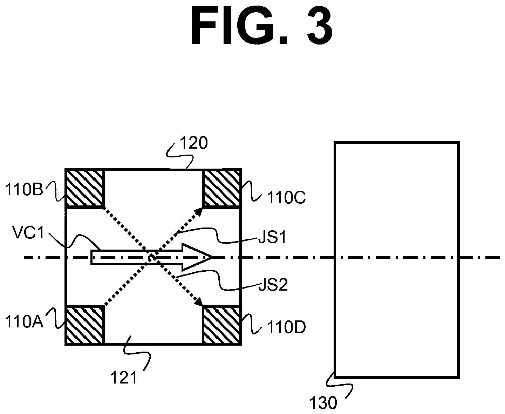

Further, as illustrated in FIG. 3, when the heat source needs to be arranged in a direction perpendicular to that of FIG. 1 and FIG. 2, the offset may be eliminated by optimizing the directions of the Hall element control currents JS1 and JS2 so as to align the center of the heat source 130 with the extension line of the vector sum VC1 of the Hall element control currents JS1 and JS2.

Fourth Embodiment

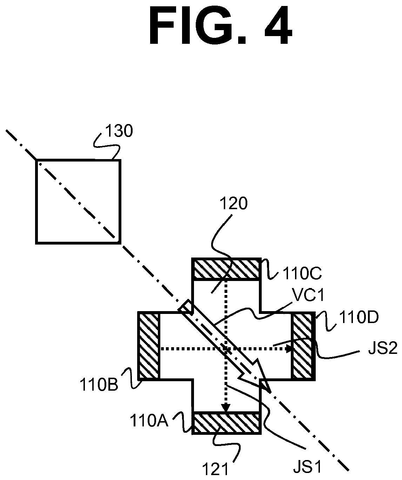

Further, the shape of the Hall element 120 is not limited to the square as illustrated in FIG. 1. As illustrated in FIG. 4, also in the Hall element 120 including the magnetism sensing portion constructed by a cross-shaped N-type doped region 121 and the Hall current control electrodes and the Hall voltage output terminals (110A to 110D) constructed by N-type highly-doped regions at four ends thereof, the influence of the heat from the heat source 130 on the offset of the Hall element may be eliminated by aligning the center of the heat source 130 with the extension line of the vector sum VC1 of the Hall element control currents JS1 and JS2.

In other words, as long as the Hall element is in a line-symmetrical shape, for example, a square or a cross shape, the offset may be eliminated by the spinning current when the center of the heat source 130 is aligned with the extension line of the vector sum VC1 of the Hall element control currents JS1 and JS2.

On this occasion, the center of the heat source means a point or a region having the highest temperature corresponding to a peak of isotherms drawn to represent a temperature gradient when the heat source is viewed from above.

The Hall element preferably has a shape that is line-symmetrical about the straight line passing through the vector sum of the currents JS1 and JS2 in the two directions by the spinning current method.

As described above, a Hall sensor that may eliminate the offset by the spinning current even when the temperature distribution in the Hall element is large, and is decreased in the chip area, thereby suppressing the cost, may be realized by decreasing the distance between the Hall element and the element that generates heat out of components of the circuit for controlling the Hall element without using a complex circuit.

Reference Signs List

10,120 Hall element
121 N-type doped region
130, 130A, 130B heat source of circuit configured to drive Hall element
110A, 110B, 110C, 110D Hall voltage output terminal and control current input terminal constructed by N-type highly-doped region
2, 12 power supply
3, 13 voltmeter
11 switching signal generator
S1, S2, S3, S4 sensor terminal switching means
T1, T2, T3, T4 terminal
R1, R2, R3, R4 resistor
JS1, JS2 Hall element control current
VC1 vector sum of Hall element control current

**Claims**

1. A Hall sensor, comprising:

   a Hall element (10,120) disposed on a semiconductor substrate;
   a heat source element (130) disposed around the Hall element, the heat source element formed as an internal component of a drive circuit, wherein a center of the heat source is a point or a region having the highest temperature in the heat source corresponding to a peak of isotherms;
   two pairs of terminals (110A,110B,110C,110D) formed as N-type highly-doped regions disposed on the Hall element, and serving both as control current input terminals and Hall voltage output terminals;
   a first Hall element control current (JS1) flowing between one pair of the terminals and a second Hall element control current (JS2) flowing between another pair of the terminals and crossing each other as vectors;
   the Hall element is formed in a shape that is line-symmetrical to a straight line extending along a vector sum (VC1) of the first Hall element control current and the second Hall element control current; wherein
   the center of the heat source element is on a straight line extending along a vector sum of the first Hall element control current and the second Hall element control current.

2. A Hall sensor according to claim 1, wherein the Hall element (10,120) comprises a magnetism sensing portion, which has a square shape or a cross shape and is symmetrical, and the control current input terminals and the Hall voltage output terminals (110A,110B, 110C,110D), which are formed at respective vertices and ends of the magnetism sensing portion, have the same shape.

3. The Hall sensor according to claim 1 or 2, further configured to eliminate an offset voltage by a spinning current.

**4.** A Hall sensor according to any preceding claim, wherein the heat source element (130) comprises two heat sources (130A,130B) and each of the heat sources is positioned on a straight line along the vector sum (VC1) of the first Hall element control current (JS1) and the second Hall element control current (JS2).

**Patentansprüche**

**1.** Hall-Sensor, umfassend:

ein Hall-Element (10, 120), das auf einem Halbleitersubstrat angeordnet ist;
ein Wärmequellenelement (130), das um das Hall-Element angeordnet ist, wobei das Wärmequellenelement als eine interne Komponente einer Antriebsschaltung gebildet ist, wobei ein Mittelpunkt der Wärmequelle ein Punkt oder ein Gebiet mit der höchsten Temperatur in der Wärmequelle entsprechend einer Spitze von Isothermen ist;
zwei Paare von Anschlüssen (110A, 110B, 110C, 110D), die als hochdotierte Gebiete vom N-Typ gebildet sind, die auf dem Hall-Element angeordnet sind und sowohl als Steuerstromeingangsanschlüsse als auch als Hall-Spannungsausgangsanschlüsse dienen;
einen ersten Hall-Elementsteuerstrom (JS1), der zwischen einem Paar der Anschlüsse fließt, und einen zweiten Hall-Elementsteuerstrom (JS2), der zwischen einem anderen Paar der Anschlüsse fließt und die einander als Vektoren schneiden;
wobei das Hall-Element in einer Form gebildet ist, die zu einer geraden Linie liniensymmetrisch ist, die sich entlang einer Vektorsumme (VC1) des ersten Hall-Elementsteuerstroms und des zweiten Hall-Elementsteuerstroms erstreckt; wobei
der Mittelpunkt des Wärmequellenelements auf einer geraden Linie liegt, die sich entlang einer Vektorsumme des ersten Hall-Elementsteuerstroms und des zweiten Hall-Elementsteuerstroms erstreckt.

**2.** Hallsensor nach Anspruch 1, wobei das Hall-Element (10, 120) einen Magnetismuserfassungsabschnitt umfasst, der eine quadratische Form oder eine Kreuzform hat und symmetrisch ist und die Steuerstromeingangsanschlüsse und die Hall-Spannungsausgangsanschlüsse (110A, 110B, 110C, 110D), die an entsprechenden Scheitelpunkten und Enden des Magnetismuserfassungsabschnitts gebildet sind, dieselbe Form aufweisen.

**3.** Hallsensor nach Anspruch 1 oder 2, ferner konfiguriert, eine Versatzspannung durch einen Spinning-Current zu eliminieren.

**4.** Hallsensor nach einem der vorangehenden Ansprüche, wobei das Wärmequellenelement (130) zwei Wärmequellen (130A, 130B) umfasst und jede der Wärmequellen auf einer geraden Linie entlang der Vektorsumme (VC1) des ersten Hall-Elementsteuerstroms (JS1) und des zweiten Hall-Elementsteuerstroms (JS2) positioniert ist.

**Revendications**

**1.** Capteur à effet Hall comprenant :

un élément à effet Hall (10, 120) disposé sur un substrat semi-conducteur ;
un élément de source de chaleur (130) disposé autour de l'élément à effet Hall, l'élément de source de chaleur étant formé en tant qu'un composant interne d'un circuit d'attaque, dans lequel un centre de la source de chaleur est un point ou une zone ayant la température la plus élevée dans la source de chaleur correspondant à un pic d'isothermes ;
deux paires de bornes (110A, 110B, 110C, 110D) formées en tant que zones fortement dopées de type N disposées sur l'élément à effet Hall, et servant à la fois de bornes d'entrée de courant de commande et de bornes de sortie de tension à effet Hall ;
un premier courant de commande d'élément à effet Hall (JS1) circulant entre une paire de bornes et un deuxième courant de commande d'élément à effet Hall (JS2) circulant entre une autre paire de bornes et se croisant l'un l'autre en tant que vecteurs ;
l'élément à effet Hall est formé en une forme à symétrie d'axe par rapport à une ligne droite s'étendant le long d'une somme vectorielle (VC1) du premier courant de commande d'élément à effet Hall et du deuxième courant de commande d'élément à effet Hall ; dans lequel
le centre de l'élément de source de chaleur est sur une ligne droite s'étendant le long d'une somme vectorielle du premier courant de commande d'élément à effet Hall et du deuxième courant de commande d'élément à effet Hall.

2. Capteur à effet Hall selon la revendication 1, dans lequel l'élément à effet Hall (10, 120) comprend une partie de détection de magnétisme qui a une forme carrée ou une forme de croix et est symétrique, et les bornes d'entrée de courant de commande et les bornes de sortie de tension à effet Hall (110A, 110B, 110C, 110D), qui sont formées au niveau respectivement de sommets et d'extrémités de la partie de détection de magnétisme, ont la même forme.

3. Capteur à effet Hall selon la revendication 1 ou 2, configuré en outre pour éliminer une tension de décalage par un courant tournant.

4. Capteur à effet Hall selon l'une quelconque des revendications précédentes, dans lequel l'élément de source de chaleur (130) comprend deux sources de chaleur (130A, 130B) et chacune des sources de chaleur est positionnée sur une ligne droite le long d'une somme vectorielle (VC1) du premier courant de commande d'élément à effet Hall (JS1) et du deuxième courant de commande d'élément à effet Hall (JS2).

# FIG. 1

# FIG. 2

# FIG. 3

# FIG. 4

# FIG. 5

# FIG. 6

# FIG. 7

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6186103 A
- JP 8330646 A
- US 2010217556 A
- WO 2005073744 A
- US 2014084911 A
- JP 2014066522 B